# EUROPÄISCHE PATENTANMELDUNG

(11) **EP 0 567 766 A1**
(43) Veröffentlichungstag der Anmeldung: **03.11.1993**
(21) Anmeldenummer: 93104507.4
(22) Anmeldetag: 19.03.1993
(51) Int. Cl.: H03H 7/46

(54) **Fahrzeug-Antennenweiche**

(30) Priorität: 25.04.1992 DE 9205615 U
(71) Anmelder: ROBERT BOSCH GMBH, 70442 Stuttgart (DE)
(72) Erfinder: Hoffmann, Peter, Dipl.-Ing., W-1000 Berlin 41 (DE); Militz, Uwe, Dipl.-Ing., W-1000 Berlin 41 (DE); Horn, Andreas, Dipl.-Ing., W-1000 Berlin 44 (DE)

(57) **Zusammenfassung**

Es wird eine Fahrzeug-Antennenweiche vorgeschlagen, die dazu dient, drei verschiedene Frequenzbereiche getrennt voneinander verschiedenen Empfängern zuzuordnen. Die Fahrzeug-Antennenweiche umfaßt drei Filter (F_{M}, F_{O}, F_{U}), die an einen Mehrbereichsstrahler (ST) angeschlossen sind und die einen von drei verschiedenen Frequenzbereichen durchlassen.

## Beschreibung

Die Erfindung geht von einer Fahrzeug-Antennenweiche nach dem Oberbegriff des Anspruchs 1 aus.

Es ist eine Fahrzeug-Antennenweiche bekannt (DE-OS 39 17 315), mit der zwei Frequenzbereiche, nämlich der UKW-Hörrundfunkbereich und ein Frequenzbereich für einen sonstigen Funkdienst, gegeneinander entkoppelt werden. Eine Fahrzeug-Antennenweiche für einen weiteren Funkdienst, der in einem anderen Frequenzbereich arbeitet, ist bisher nicht verfügbar.

Der Erfindung liegt die Aufgabe zugrunde, die bekannte Fahrzeug-Antennenweiche derart weiterzubilden, daß mit ihr mehr als zwei Frequenzbereiche entkoppelt werden können.

Diese Aufgabe wird durch eine Fahrzeug-Antennenweiche nach dem Anspruch 1 gelöst. Damit ist der Vorteil verbunden, daß an einen Mehrbereichsstrahler über die Fahrzeug-Antennenweiche ein Autoradio, ein Mobiltelefon für das C-Netz und ein Mobiltelefon für das D-Netz angeschlossen werden können, ohne daß sich die in verschiedenen Frequenzbereichen arbeitenden Geräte hochfrequenzmäßig gegenseitig stören. Es ist sogar gegebenenfalls möglich, alle Geräte gleichzeitig zu betreiben.

Vorteilhafte Weiterbildungen der Fahrzeug-Antennenweiche gehen aus den Unteransprüchen hervor. Besonders vorteilhaft ist eine Fahrzeug-Antennenweiche, bei der alle drei Filter Bandpaßfilter sind. Dadurch wird verhindert, daß oberhalb des oberen oder unterhalb des unteren Frequenzbereiches liegende Signalfrequenzen an die angeschlossenen Geräte gelangen, die anderenfalls zu Störungen Anlaß geben können.

Ausführungsbeispiele der Erfindung sind in der Zeichnung an Hand mehrerer Figuren dargestellt und werden im folgenden näher erläutert. Es zeigen
- Fig. 1: ein Blockschaltbild einer erfindungsgemäßen Fahrzeug-Antennenweiche für eine Mehrbereichsantenne und drei daran angeschlossene Funkgeräte,
- Fig. 2: ein ausführliches Schaltbild einer Fahrzeug-Antennenweiche in einer ersten Ausführung,
- Fig. 3: ein ausführliches Schaltbild einer Fahrzeug-Antennenweiche in einer zweiten Ausführung und
- Fig. 4: ein ausführliches Schaltbild einer Fahrzeug-Antennenweiche in einer dritten Ausführung.

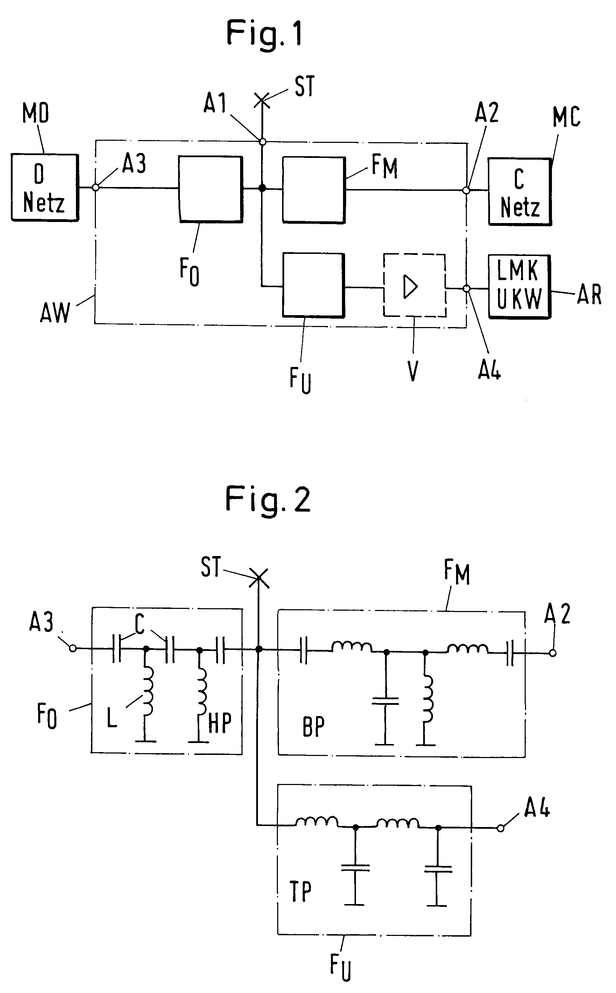

In Fig. 1 bezeichnet ST einen Mehrbereichsstrahler, dessen Fußpunkt mit einem ersten Anschluß A1 einer Fahrzeug-Antennenweiche AW verbunden ist. Der erste Anschluß A1 steht über ein erstes Filter F_{M} mit einem zweiten Anschluß A2, über ein zweites Filter F_{O} mit einem dritten Anschluß A3 und über ein drittes Filter F_{U} und gegebenenfalls einen Hochfrequenzverstärker V mit einem vierten Anschluß A4 in Verbindung. Das erste Filter F_{M} läßt nur Hochfrequenzsignale eines mittleren Frequenzbereiches, das ist zum Beispiel der Frequenzbereich für Mobiltelefone des C-Netzes, das zweite Filter F_{O} nur Hochfrequenzsignale eines Frequenzbereiches oberhalb des mittleren Frequenzbereiches, das ist zum Beispiel der Frequenzbereich für Mobiltelefone des D-Netzes, und das dritte Filter F_{U} nur Hochfrequenzsignale eines Frequenzbereiches unterhalb des mittleren Frequenzbereiches, das ist zum Beispiel der UKW-Hörrundfunkbereich, an die zugehörigen Anschlüsse A2, A3, A4 durch. An die Anschlüsse A2, A3 und A4 sind ein C-Netz-Mobiltelefon MC, ein D-Netz-Mobiltelefon MD und ein Autoradio AR angeschlossen. Die drei Filter F_{M}, F_{O} und F_{U} sind, wie in Fig. 2 gezeigt, durch ein Bandpaßfilter BP, ein Hochpaßfilter HP und ein Tiefpaßfilter TP realisiert. Alle Filter sind vorzugsweise passive LC-Filter.

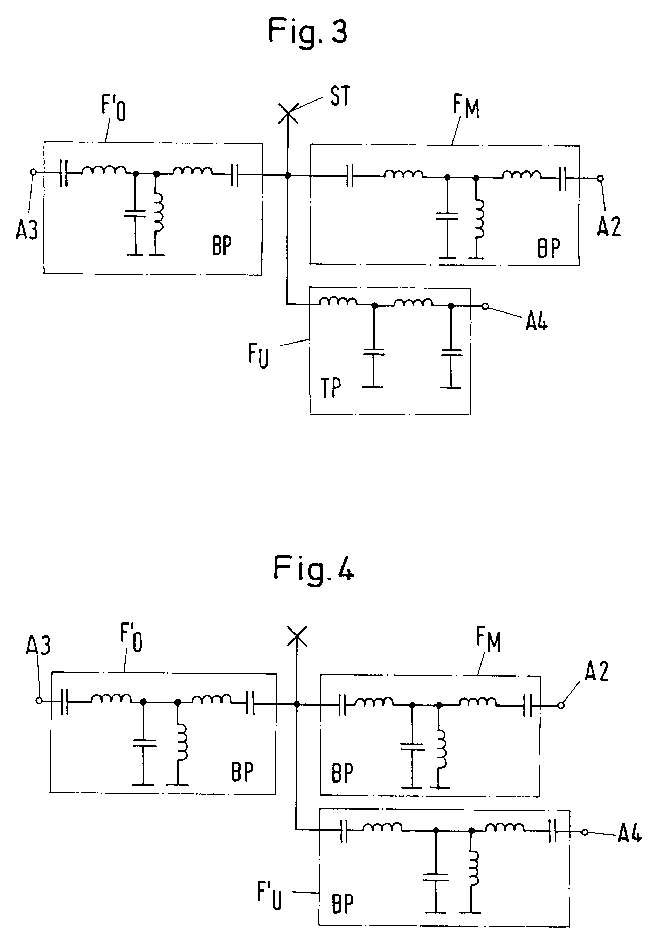

In einer in Fig. 3 gezeigten Variante zu der Fahrzeug-Antennenweiche nach Fig. 2 ist das zweite Filter F'_{O} der Fahrzeug-Antennenweiche ebenso wie das erste Filter F_{M} ein Bandpaßfilter.

In einer in Fig. 4 gezeigten dritten Ausführung einer Fahrzeug-Antennenweiche sind alle drei Filter F_{M}, F'_{O} und F'_{U} Bandpaßfilter.

## Patentansprüche

1. Fahrzeug-Antennenweiche, dadurch gekennzeichnet, daß die Antennenweiche (AW) drei eingangsseitig mit einem gemeinsamen Mehrbereichsstrahler (ST) verbundene Filter (F_{M}, F_{O}, F_{U}) umfaßt, von denen ein erstes Filter (F_{M}) zum Durchlassen von Hochfrequenzsignalen eines mittleren Frequenzbereiches, ein zweites Filter (F_{O}) zum Durchlassen von Hochfrequenzsignalen eines oberen Frequenzbereiches und ein drittes Filter (F_{U}) zum Durchlassen von Hochfrequenzsignalen eines unteren Frequenzbereiches vorgesehen ist.

2. Fahrzeug-Antennenweiche nach Anspruch 1, dadurch gekennzeichnet, daß das erste Filter (F_{M}) ein Bandpaßfilter (BP) ist.

3. Fahrzeug-Antennenweiche nach Anspruch 1 oder 2, dadurch gekennzeichnet, daß das zweite Filter (F_{O}) ein Hochpaßfilter (HP) ist.

4. Fahrzeug-Antennenweiche nach Anspruch 1, 2 oder 3, dadurch gekennzeichnet, daß das dritte Filter (F_{U}) ein Tiefpaßfilter (TP) ist.

5. Fahrzeug-Antennenweiche nach Anspruch 2, dadurch gekennzeichnet, daß das erste Filter (F_{M}) und das zweite Filter (F_{O}) je ein Bandpaßfilter (BP) sind.

6. Fahrzeug-Antennenweiche nach einem der Ansprüche 1 bis 5, dadurch gekennzeichnet, daß die Filter (F_{M}, F_{O}, F_{U}) passive LC-Filter sind.

7. Fahrzeug-Antennenweiche nach Anspruch 1, 2 oder 5, dadurch gekennzeichnet, daß alle Filter (F_{M}, F'_{O}, F'_{U}) Bandpaßfilter (BP) sind.

8. Fahrzeug-Antennenweiche nach einem der Ansprüche 1 bis 6, dadurch gekennzeichnet, daß zu der Fahrzeug-Antennenweiche (AW) ein Hochfrequenzverstärker (V) gehört, der dem dritten Filter (F_{U}) nachgeschaltet ist.
